Europäisches Patentamt

European Patent Office

Office européen des brevets

(11) Numéro de publication : **0 449 720 B1**

(19)

## (12) FASCICULE DE BREVET EUROPEEN

(45) Date de publication du fascicule du brevet :
26.10.94 Bulletin 94/43

(51) Int. Cl.⁵ : **G01S 13/82, H03F 3/60,**
**G06K 7/10**

(21) Numéro de dépôt : **91400806.5**

(22) Date de dépôt : **26.03.91**

(54) Antenne active de transmission bidirectionnelle.

(30) Priorité : **27.03.90 FR 9003879**

(43) Date de publication de la demande :
**02.10.91 Bulletin 91/40**

(45) Mention de la délivrance du brevet :
**26.10.94 Bulletin 94/43**

(84) Etats contractants désignés :
**DE GB NL SE**

(56) Documents cités :
**EP-A- 0 023 275**
**EP-A- 0 343 034**
**WO-A-89/11701**
**FR-A- 2 624 677**
**US-A- 4 104 630**
**US-A- 4 504 796**
**US-A- 4 591 803**

(73) Titulaire : **THOMSON-CSF**
**SEMICONDUCTEURS SPECIFIQUES**
**173, Boulevard Haussmann**
**F-75008 Paris (FR)**

(72) Inventeur : **Camiade, Marc**
**THOMSON-CSF,**
**SCPI-CEDEX 67**
**F-92045 Paris La Defense (FR)**
Inventeur : **Serru, Véronique**
**THOMSON-CSF,**
**SCPI-CEDEX 67**
**F-92045 Paris La Defense (FR)**
Inventeur : **Geffroy, Dominique**
**THOMSON-CSF,**
**SCPI-CEDEX 67**
**F-92045 Paris La Defense (FR)**

(74) Mandataire : **Taboureau, James et al**
**THOMSON-CSF,**
**SCPI,**
**B.P. 329,**
**50, rue Jean-Pierre Timbaud**
**F-92402 Courbevoie Cédex (FR)**

## Description

La présente invention concerne un circuit de communication bidirectionnelle, par ondes hyperfréquences, entre une station centrale ou balise fixe, équipée d'un système d'émission et de réception de signaux, et une station terminale ou dispositif mobile, autonome en énergie. Plus précisément, l'invention concerne un circuit dénommé "antenne active" qui, dans le dispositif mobile de type badge portable, assure une veille des signaux d'interrogation et, les ayant détectés, active le dispositif mobile afin qu'il émette à son tour, avec plus de puissance, des signaux codés en réponse à l'interrogation.

Ce type d'échange de données trouve une application, par exemple, dans le télépéage, la télébilletique ou l'identification ou localisation de mobiles. Le dispositif mobile se présente comme une carte à puce, portée par une personne, ou un objet en défilement. Alimenté par de petites piles "boutons", il doit être extrêmement économe en énergie.

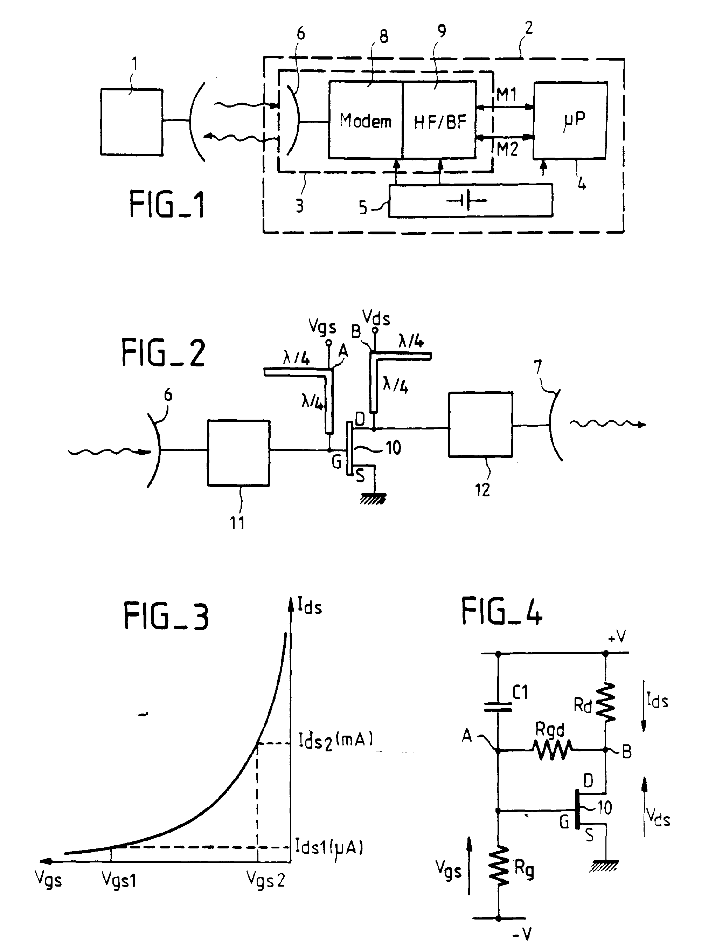

Le schéma d'ensemble de ce type d'échange de données est en soi connu, et est rappelé en figure 1. Une balise 1 échange des signaux hyperfréquences avec un badge portable 2 qui comprend une antenne active 3 et des circuits de commande 4, les deux étant alimentés en énergie par une alimentation 5, essentiellement une ou plusieurs piles.

L'antenne active 3 comprend elle-même :
- une ou deux antennes 6-7 d'émission-réception,
- un circuit hyperfréquence, modem 8, pour moduler et démoduler l'information transmise, sous forme d'impulsions logiques,
- un circuit d'interface 9 hyperfréquence-basses fréquences, pour permettre la liaison avec les circuits de commande 4 qui comportent par exemple un microprocesseur et des mémoires.

La modulation utilisée dans cette application est de type OOK , c'est à dire une modulation d'amplitude en tout ou rien de la porteuse hyperfréquence. En mode interrogation, la balise émet une onde modulée, impulsions ou créneaux. En mode réception, la balise émet une onde pure et le badge portable émet une onde modulée.

Par conséquent, le badge doit pouvoir fonctionner dans deux états :
- en réception, sous une très faible consommation d'énergie (quelques microampéres), car c'est son état quasi-permanent, il doit pouvoir recevoir et démoduler un signal d'interrogation émis par la balise fixe,
- en émission, après avoir identifié un interrogateur, il doit pouvoir émettre avec une puissance suffisante (quelques milliampères) un signal à modulation personnalisée.

Il faut donc commuter le badge portable, pour le faire passer d'un état à un autre état, de la façon la plus simple possible pour que la consommation à l'état de veille soit très faible.

Pour une application dans le même domaine, le brevet US-A-4 104 630 décrit un badge dans lequel la réception et la démodulation d'un signal d'interrogation se font au moyen d'une diode tunnel. A l'émission, un générateur de mots émet à travers la diode tunnel sa réponse à l'interrogation. Mais la diode ne remplace pas l'amplificateur assuré par un circuit à trois étages de transistors. Plus récemment, le document EP-A-2 624 677 décrit un dispositif dont le principe est assez semblable, et dans lequel un modem à diode est suivi par un amplificateur, mais, le texte ne précise pas les conditions de polarisation de la diode.

Selon l'invention, les fonctions de détection et d'émission, ainsi que l'organe de commutation, sont assurées par un seul dispositif semiconducteur qui est soit un transistor à effet de champ, soit un amplificateur à transistors à effet de champ. Par déplacement du point de polarisation de ce transistor, celui-ci fonctionne soit en un excellent détecteur d'une onde hyperfréquence, soit en amplificateur. Le déplacement du point de polarisation est lui-même obtenu par la commutation entre deux jeux de résistances commandées par des signaux provenant des circuits de commande 4.

De façon plus précise, l'invention concerne une antenne active conformément à la revendication 1.

L'invention sera mieux comprise par la description détaillée qui suit d'un exemple d'application, en liaison avec les figures jointes en annexe, qui représentent :
- figure 1 : schéma d'ensemble d'un système d'échange de données par ondes hyperfréquences, exposé précédemment,
- figure 2 : schéma de montage d'un transistor en détecteur-amplificateur, selon l'invention,
- figure 3 : courbe de caractéristique $I_{ds} = f(V_{gs})$, telle qu'utilisée dans le montage selon l'invention,
- figure 4 : réseau de polarisation d'un transistor, selon l'invention
- figure 5 : diagramme dans le temps des signaux de commutation,
- figure 6 : schéma électrique de l'antenne active selon l'invention.

De façon à rendre les explications plus claires, l'invention sera exposée en choisissant comme composant actif un transistor à effet de champ, ce qui ne limite pas la portée de l'invention : un amplificateur de type MMIC a également un transistor à effet de champ comme étage d'entrée.

Ce transistor est, dans l'état actuel de la technique, et compte tenu des fréquences utilisées (1 à 100 GHz), préférentiellement en GaAs ou en matériaux de type III-V, tels que GaAlAs, InP... etc. Cependant, l'invention couvre également l'utilisation de transistors en silicium, lorsqu'ils sont poussés à leurs fréquences extrêmes, de l'ordre de quelques gigahertz.

La partie hyperfréquence 8, ou modulateur-démodulateur de la figure 1, utilise un transistor à effet de champ couplé à deux antennes, comme montré en figure 2.

Le signal d'entrée, issu de la balise fixe 1, est reçu par l'antenne 6 de détection : il est appliqué sur la grille du transistor 10 à travers un premier réseau d'adaptation 11. Celui-ci, composé d'éléments de microbandes de longueur $\lambda$ g</4 ($\lambda$g = longueur d'onde guidée) résulte d'un compromis entre l'adaptation de l'impédance de grille du transistor dans l'état "réception" et l'impédance de grille du transistor dans l'état "émission", vis à vis de l'antenne 6, qui est imprimée.

La source du transistor 10 est à la masse.

Sur le drain est monté un second réseau d'adaptation d'impédance 12, entre le transistor 10 et l'antenne d'émission 7. Ce second réseau d'adaptation 12 est constitué, comme le premier réseau 11, d'éléments de ligne adaptés. Il permet, dans l'état "réception", l'extraction du signal démodulé, qui est adressé en basse fréquence, par une sortie démodulée non représentée sur cette figure, au circuit de commande 4. Il permet également, dans l'état "émission" l'adaptation d'impédance du drain vis à vis de l'antenne 7, également imprimée.

Les deux antennes 6 et 7 sont constituées par des fentes dans le plan de masse du substrat diélectrique qui supporte le transistor 10 et les éléments de ligne. Sur la face côté transistor, deux éléments de ligne coupent à angle droit les deux fentes démétallisées de l'autre face.

Les tensions de polarisations $V_{gs}$ et $V_{ds}$ sont appliquées sur la grille et le drain du transistor 10 à travers un réseau de lignes de longueurs $\lambda$ g/4. Soit A et B les points en lesquels sont appliquées, respectivement, les tensions $V_{gs}$ et $V_{ds}$.

Selon l'invention, on force le transistor 10 à fonctionner sous deux polarisations : suivant son point de polarisation, un transistor à effet de champ constitue un excellent détecteur de puissance, ou un amplificateur. La figure 3 donne la caractéristique $I_{ds} = f (V_{gs})$ du courant de drain en fonction de la tension de grille.

En réception, le transistor 10 fonctionne à très faible courant de drain ($I_{ds1}$ = quelques μA), et il se comporte en détecteur car il fonctionne sur le coude de la caractéristique $I_{ds} (V_{gs})$, dans la région où elle n'est pas linéaire autour de la tension de pincement. La sensibilité de détection ainsi obtenue est généralement supérieure à celle que l'on aurait pu obtenir avec des diodes Schottky. Dans ces conditions de fonctionnement, le transistor 10 constitue le démodulateur de l'antenne active, et il transmet les signaux d'interrogation émis par la balise fixe.

En émission, le point de polarisation du transistor 10 est déplacé de façon à obtenir un courant $I_{ds2}$ de quelques milliampères. Les moyens de commutation seront exposés ultérieurement. Le transistor se comporte alors en amplificateur, dont il suffit de moduler la tension de polarisation de grille $V_{gs}$ ou de drain $V_{ds}$ pour engendrer une modulation d'amplitude : le transistor 10 constitue un modulateur. En outre, il y a gain de réémission et par conséquent augmentation de la portée du badge.

La commutation d'un état à l'autre se fait par commutation de résistances, sous l'effet de commandes M1 et M2, impulsions émises par le circuit de commande 4. Mais avant d'aborder l'exposé des moyens mis en oeuvre pour faire commuter le badge, il est nécessaire d'exposer le circuit à contre réaction qui a été mis au point pour éviter le tri des composants, au cours de la fabrication du badge.

En effet, ce badge hyperfréquence est un produit de type "grand public", fabriqué en grandes quantités, et sur lequel il est indispensable d'éliminer tous les réglages liés à la dispersion des caractéristiques des composants. Actuellement, ce sont les caractéristiques statiques du transistor hyperfréquence qui sont les plus dispersives. Pour éviter un tri trop sévère de ce composant, ce qui en augmenterait le prix, un circuit de contre-réaction, représenté en figure 4, a été mis au point. Son but est de corriger la tension $V_{gs}$ en fonction du courant $I_{ds}$, et donc de la tension $V_{ds}$, de polarisation du transistor.

Ce circuit très simple comprend :
- une résistance de drain $R_d$, branchée entre le drain et la source de polarisation positive + V,
- une résistance de grille $R_g$, branchée entre la grille et la source de polarisation négative - V,
- une résistance grille-drain $R_{gd}$, montée en pont entre la grille et le drain, les trois résistances $R_g$, $R_{gd}$ et $R_d$ étant en série.

On a :

$$ |V_{gs}| = \frac{R_g}{R_g + R_{gd}} (2 V - R_d I_{ds}) $$

avec $R_g$ et $R_{gd} \gg R_d$

Lorsque $I_{ds}$ augmente, $|V_{gs}|$ diminue et entraîne une diminution de $I_{ds}$. Et inversement si $I_{ds}$ diminue. On a ainsi établi une relation entre le courant de polarisation $I_{ds}$ et la tension de grille $V_{gs}$ qui permet l'utilisation de transistors ayant une dispersion de caractéristiques statiques beaucoup plus élevée que sans contre-réaction. Ce circuit de contre-réaction permet d'accroître d'un facteur supérieur à 10 la dispersion acceptable sur la tension $\Delta V_{gs}$, pour un même courant $I_{ds}$, par rapport à un montage sans contre-réaction.

Pour les mêmes raisons, ce circuit donne une meilleure maîtrise du point de polarisation en fonction de la fluctuation de la tension des piles qui fournissent + V et - V.

Ce circuit d'asservissement fonctionne dans les deux états de polarisation du transistor.

En réception, lorsque le transistor fonctionne en démodulateur avec une polarisation à courant $I_{ds}$, très faible, les résistances $R_g$ et $R_{gd}$ ont des valeurs très élevées ($\sim$10 M$\Omega$) de façon à ne pas perdre d'énergie dans le pont diviseur $R_g$ - $R_{gd}$, et la résistance de drain $R_d$ a une valeur de l'ordre de 100 k$\Omega$ . Il est également nécessaire d'ajouter une capacité $C_1$, entre la tension d'alimentation + V et la grille du transistor, de façon à annuler l'effet de la contre-réaction à la fréquence de démodulation. En effet, celle-ci atténuerait fortement le courant de détection puisque son but est de réguler le courant $I_{ds}$.

En émission, lorsque le transistor fonctionne en modulateur-amplificateur, avec un courant $I_{ds}$ de quelques milliampères, la résistance de drain $R_d$ doit être commutée sur une valeur de l'ordre de 0,1 k$\Omega$, pour permettre le gain, et les résistances $R_g$ et $R_{gd}$ de valeurs plus faibles ($\sim$ 10 k$\Omega$) de façon à supprimer tous les effets liés aux constantes de temps.

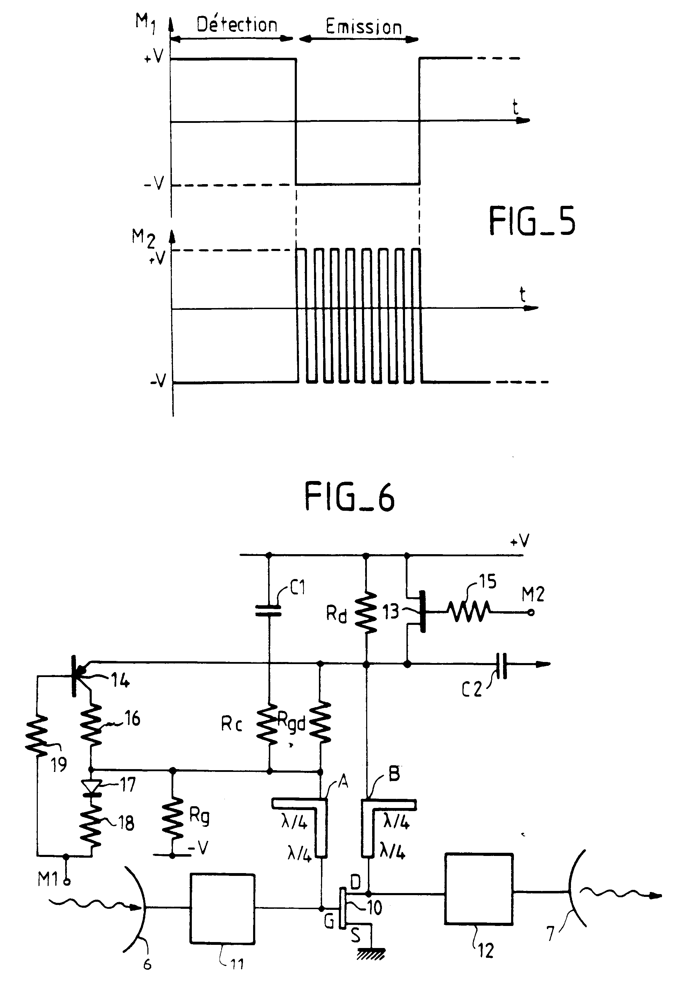

La commutation des résistances se fait au moyen de deux transistors, selon le schéma de la figure 6, et sous l'action de deux signaux de commande M1 et M2, qui agissent selon le diagramme de la figure 5.

M1 et M2 sont émis par les circuits de commande 4. Le signal M1 qui commande le changement du point de polarisation du transistor, est égal à + V tant que le badge est à l'état de détection -c'est à dire la majeure partie du temps- et il est égal à - V pendant le temps d'émission de signaux par le badge. Tant que M1 est à + V, le signal M2 est à -V, et pendant le temps d'émission M2 est un signal en créneaux entre + V et -V, à une fréquence de l'ordre de 100KHz à 1MHz.

En figure 6, on voit que le signal M1 est appliqué sur la base d'un transistor bipolaire PNP 14, à travers une résistance 19. L'émetteur de ce transistor 14 est réuni au point commun entre $R_d$ et $R_{gd}$, et le collecteur est réuni à travers une résistance 16, au point commun entre $R_{gd}$ et $R_g$. A partir de ce point commun, une diode 17 et une résistance 18 rebouclent sur le terminal d'entrée du signal M1.

Par ailleurs, le signal M2 est appliqué, à travers une résistance 15 ($\sim$ 100 k$\Omega$), sur la grille d'un transistor à effet de champ 13, monté en dérivation sur la résistance $R_d$. Au point commun entre $R_d$ et $R_{gd}$, une sortie envoie vers les circuits de commande 4 les signaux démodulés, au cours de l'interrogation du badge par la balise fixe.

Lorsque le signal M1 est à -V, la diode 17 et le transistor 14 sont conducteurs : le point de polarisation du transistor 10 est fixé par les résistances 16 et 18, ainsi que par les valeurs fixes des tensions de saturation de la diode 17 et du transistor 14. En effet, les résistances 16 et 18 sont de faibles valeurs ($\sim$ 10 k$\Omega$) comparées à celles de $R_{gd}$ et $R_g$ ($\sim$ 10 M$\Omega$) et ces deux ponts diviseurs sont montés en parallèle. Dans cet état, le transistor 10 fonctionne en amplificateur : la modulation des signaux émis lui est imposée par le signal M2, sur son drain.

Pendant la détection (M1 = +V) le signal M2 est à - V, le transistor 13 est bloqué, et la résistance $R_g$ et $R_{gd}$ ($\sim$ 10 M$\Omega$) imposent un courant $I_{ds}$ faible.

Pendant l'émission (M1 = - V) le signal M2 est modulé entre + V et - V. Lorsque M2 = + V, le transistor 13 est débloqué, et la résistance $R_d$ ($\sim$ 100 k$\Omega$) est shuntée par la résistance équivalente drain-source du transistor 13 ($\sim$ 0,1k$\Omega$), qui régule le courant $I_{ds}$ du transistor 10 par contre-réaction. Lorsque M2 = -V, la résistance $R_d$ est élevée puisque le transistor 13 est bloqué : la tension $V_{ds}$ du transistor 10 est inférieure à OV et il présente des pertes élevées aux hyperfréquences. On a donc réalisé, à l'aide du signal M2, une modulation d'amplitude du signal de drain, émis par l'antenne 7 à travers le réseau d'adaptation 12.

On a introduit une résistance $R_c$, de l'ordre de 100 k$\Omega$, en série avec $C_1$ pour les raisons suivantes :
- en réception elle est sans effet puisque sa valeur est très inférieure à $R_{gd}$ et $R_g$ et la capacité $C_1$ joue bien son rôle
- en émission elle annule l'effet de la capacité $C_1$ puisque $R_c$ est très supérieure à $R_{16}$ et $R_{18}$. En effet compte tenu des fréquences de démodulation du signal hyperfréquence pouvant aller jusqu'à 1 MHz, il est nécessaire de s'affranchir de la constante de temps en émission induite par $C_1$.

Si l'on considère que les transistors 13 et 14 ne sont que des moyens de commutation, il apparaît que l'antenne active 3 du badge portable ne comporte qu'un seul transistor 10 qui, selon le point de polarisation qui lui est imposé par le circuit de contre-réaction, fonctionne en détecteur/démodulateur ou en émetteur/modulateur.

L'invention a été exposée en s'appuyant sur l'exemple d'un transistor à effet de champ 10 : il est évident que celui-ci peut être soit en matériaux rapides de genre GaAs, GaAlAs... ou en silicium, compte tenu des progrès récents en fréquences des semiconducteurs en silicium. L'unique transistor 10 peut également n'être que l'étage d'entrée d'un amplificateur en circuit intégré, comportant plusieurs étages.

De la même façon, il a été écrit, pour fixer les idées, que la balise est fixe et le badge hyperfréquence mobile. L'invention demeure valable si une balise, qui constitue un système d'interrogation, défile devant des badges fixes, puisque, de façon générale, l'invention concerne un système d'échange de données par hyperfréquences entre un dispositif interrogateur et un dispositif répondeur.

## Revendications

1. Antenne active pour station terminale d'un système de transmission bidirectionnelle d'informations, par modulation/démodulation d'une porteuse hyperfréquence, entre une station centrale, qui émet de premiers signaux modulés d'interrogation, et la station terminale, qui lui répond par de seconds signaux modulés, comprenant un élément d'antenne et caractérisée en ce qu'elle comprend un moyen de modulation/démodulation constitué par un premier transistor (10) à effet de champ qui est connecté audit élément d'antenne par sa grille et qui, sous un premier courant de drain ($I_{ds}$) de faible valeur, se comporte en démodulateur de signaux reçus, et, sous un second courant de drain de valeur plus élévée, se comporte en amplificateur-modulateur à l'émission pour réemettre les signaux reçus, ce transistor (10) étant assisté par un circuit de commutation du courant de drain ($I_{ds}$) constitué par trois résistances ($R_d, R_{gd}, R_g$) dont les valeurs sont commutables au moyen d'un deuxième et d'un troisième transistors (13,14).

2. Antenne active selon la revendication 1, caractérisée en ce que les trois résistances ($R_d, R_{gd}, R_g$) du circuit de commutation du courant de polarisation du premier transistor (10) sont de valeurs élevées, montées en série entre les deux pôles (+V, -V) d'une alimentation en tension (5), la seconde résistance ($R_{gd}$) de cette série étant connectée entre la grille et le drain du premier transistor (10) dont la source est à la masse, ces trois résistances ($R_d, R_{gd}, R_g$) étant commutées d'une valeur élevée dans l'état démodulation à une valeur faible dans l'état modulation au moyen des deuxième et troisième transistors (13,14) montés en parallèle avec elles et commandés par deux signaux de commutation (M1,M2) qui prennent alternativement les valeurs positives (+V) et négatives (-V) de l'alimentation (5).

3. Antenne active selon la revendication 2 caractérisée en ce que :
   - la première résistance ($R_d$) ou résistance de drain est montée en parallèle avec le deuxième transistor, du type à effet de champ (13), dont la grille est commandée par le second signal (M2) issu d'un circuit de commande (4) de la station terminale,
   - le pont diviseur, formé par la seconde résistance ($R_{gd}$) ou résistance grille-drain et par la troisième résistance ($R_g$) ou résistance de grille, est monté en parallèle avec un second pont diviseur formé par une quatrième et une cinquième résistances (16,18) de faibles valeurs, le point commun aux seconde et troisième résistances ($R_{gd}, R_g$) étant réuni au point commun à la quatrième résistance (16) et à une diode (17) en série avec la cinquième résistance, la commutation entre le premier et le second ponts diviseurs étant assurée par le troisième transistor (14), du type bipolaire, dont la base est commandée par le premier signal (M1) issu d'un circuit de commande (4), ce premier signal (M1) étant en outre appliqué sur la cinquième résistance (18) du second pont diviseur.

4. Antenne active selon la revendication 3, caractérisée en ce que, dans l'état de démodulation, le premier signal (M1) est égal à la tension négative (-V) et le second signal (M2) est modulé entre la tension positive (+V) et la tension négative (-V) de l'alimentation (5).

5. Antenne active selon la revendication 2, caractérisée en ce qu'une capacité (C1) est montée entre la grille du premier transistor (10) et la tension positive (+ V) de l'alimentation (5), de valeur telle que sa constante de temps soit supérieure à la période de modulation du signal d'interrogation.

6. Antenne active selon la revendication 2, caractérisée en ce qu'une sortie démodulée est prélevée sur le drain du premier transistor (10) et adressée au circuit de commande (4) de la station terminale (2).

7. Antenne active selon la revendication 1, caractérisée en ce que le premier transistor (10) est l'étage d'entrée d'un amplificateur en circuit intégré.

8. Antenne active selon la revendication 1, caractérisée en ce qu'elle travaille dans la gamme hyperfréquence de 1 à 100 GHz.

## Patentansprüche

1. Aktivantenne für die Terminalstation eines Systems zur Zweirichtungs-Übertragung von Informationen durch Modulation/Demodulation einer ultrahochfrequenten Trägerwelle zwischen einer Zentralstation, die erste modulierte Abfragesignale aussendet, und der Terminalstation, die ihr mit zweiten modulierten Signalen antwortet, die ein Antennenelement aufweist und dadurch gekennzeichnet ist, daß sie eine Modulations-/Demodulationseinrichtung aufweist, die durch einen ersten Feldeffekttransistor (10) gebildet ist, der mit dem Antennenelement über seinen Gate-Anschluß verbunden ist und der sich unter einem ersten Drain-Strom ($I_{ds}$) mit niedrigem Wert als Demodulator für empfangene Signale verhält und sich unter einem zweiten Drain-Strom mit höherem Wert als Sendemodulatorverstärker verhält, um die empfangenen Signale erneut auszusenden, wobei dieser Transistor (10) durch einen Schaltkreis für den Drainstrom ($I_{ds}$) unterstützt wird, der aus drei Widerständen

($R_d$, $R_{gd}$, $R_g$) gebildet ist, deren Werte mittels eines zweiten und dritten Transistors (13, 14) umschaltbar sind.

2. Aktivantenne nach Anspruch 1, dadurch gekennzeichnet, daß die drei Widerstände ($R_d$, $R_{gd}$, $R_g$) des Schaltkreises für den Polarisierungsstrom des ersten Transistors (10) hohe Werte aufweisen und zwischen die beiden Pole (+V, -V) einer Spannungsversorgung (5) in Reihe geschaltet sind, wobei der zweite Widerstand ($R_{gd}$) dieser Reihe zwischen den Gate-Anschluß und den Drain-Anschluß des ersten Transistors (10) geschaltet ist, dessen Source-Anschluß an Masse liegt, wobei diese drei Widerstände ($R_d$, $R_{gd}$, $R_g$) mittels des zweiten und des dritten Transistors (13, 14) von einem hohen Wert im Demodulationszustand in einen niedrigen Wert im Modulationszustand umgeschaltet werden, die mit ihnen parallel geschaltet und durch zwei Schaltsignale (M1, M2) gesteuert werden, die alternativ den positiven Wert (+V) und den negativen Wert (-V) der Versorgung (5) annehmen.

3. Aktivantenne nach Anspruch 2, dadurch gekennzeichnet, daß:
   - der erste Widerstand ($R_d$) oder Drain-Widerstand mit dem zweiten Feldeffekttransistor (13) parallelgeschaltet ist, dessen Gate-Anschluß durch das zweite Signal (M2) gesteuert wird, das von einer Steuerschaltung (4) der Terminalstation geliefert wird,
   - die durch den zweiten Widerstand ($R_{gd}$) oder Gate-Drain-Widerstand und den dritten Widerstand ($R_g$) oder Gate-Widerstand gebildete Teilerbrücke mit einer zweiten Teilerbrücke parallelgeschaltet ist, die durch einen vierten und einen fünften Widerstand (16, 18) mit geringen Werten gebildet ist, wobei der dem zweiten und dritten Widerstand (Rgd, Rg) gemeinsame Punkt mit dem dem vierten Widerstand (16) und einer Diode (17) in Reihe mit dem fünften Widerstand gemeinsamen Punkt verbunden ist, wobei die Umschaltung zwischen der ersten und der zweiten Teilerbrücke durch den dritten Transistor (14) des Bipolartyps sichergestellt ist, dessen Basis durch das erste Signal (M1) aus einer Steuerschaltung (4) gesteuert wird, wobei dieses erste Signal (M1) ferner an den fünften Widerstand (18) der zweiten Teilerbrücke angelegt wird.

4. Aktivantenne nach Anspruch 3, dadurch gekennzeichnet, daß das erste Signal (M1) im Demodulationszustand gleich der negativen Spannung (-V) ist und das zweite Signal (M2) zwischen der positiven Spannung (+V) und der negativen Spannung (-V) der Versorgung (5) moduliert wird.

5. Aktivantenne nach Anspruch 2, dadurch gekennzeichnet, daß zwischen den Gate-Anschluß des ersten Transistors (10) und die positive Spannung (+V) der Versorgung (5) eine Kapazität (C1) mit einem solchen Wert geschaltet ist, daß ihre Zeitkonstante größer als die Modulationsperiode des Abfragesignals ist.

6. Aktivantenne nach Anspruch 2, dadurch gekennzeichnet, daß ein demoduliertes Ausgangssignal am Drain-Anschluß des ersten Transistors (10) abgenommen und an die Steuerschaltung (4) der Terminalstation (2) gerichtet wird.

7. Aktivantenne nach Anspruch 1, dadurch gekennzeichnet, daß der erste Transistor (10) die Eingangsstufe eines als integrierte Schaltung ausgebildeten Verstärkers ist.

8. Aktivantenne nach Anspruch 1, dadurch gekennzeichnet, daß sie im Höchstfrequenzbereich von 1 bis 100 GHz arbeitet.

## Claims

1. Active antenna for a terminal station of a system for bidirectional information transmission, by modulation/demodulation of a UHF carrier, between a central station, which sends out first modulated interrogation signals, and the terminal station, which responds to it via second modulated signals, comprising an antenna element and characterized in that it comprises a modulation/demodulation means consisting of a first field-effect transistor (10) which is connected to the said antenna element by the gate and which, at a first drain current ($I_{ds}$) of low value behaves as a demodulator of received signals, and, at a second drain current of higher value, behaves as an amplifier-modulator on transmission in order to retransmit the received signals, this transistor (10) being assisted by a circuit for switching the drain current ($I_{ds}$) consisting of three resistors ($R_d$, $R_{gd}$, $R_g$) the values of which are switchable by means of a second and of a third transistors (13, 14).

2. Active antenna according to Claim 1, characterized in that the three resistors ($R_d$, $R_{gd}$, $R_g$) of the circuit for switching the bias current of the first transistor (10) are of high values, mounted in series between the two poles (+V, -V) of a voltage supply (5), the second resistor ($R_{gd}$) of this series being connected between the gate and the drain of the first transistor (10), the source of which is earthed, these three resistors ($R_d$, $R_{gd}$, $R_g$) being switched from a high value in the demodulation state to a low value in the modulation state by means of the second and third transistors (13, 14) mounted in parallel with them and controlled by two switching signals (M1, M2) which alternately take the positive (+V) and negative (-V) values of the power supply (5).

3. Active antenna according to Claim 2, characterized in that:
   - the first resistor ($R_d$) or drain resistor is mounted in parallel with the second transistor of the field-effect type (13), the gate of which is controlled by the second signal (M2) originating from a control circuit (4) of the terminal station,
   - the divider bridge, formed by the second resistor ($R_{gd}$) or gate-drain resistor and by the third resistor ($R_g$) or gate resistor, is mounted in parallel with a second divider bridge formed by a fourth and a fifth resistors (16, 18) of low values, the point which is common to the second and third resistors ($R_{gd}$, $R_g$) being joined to the point common to the fourth resistor (16) and to a diode (17) in series with the fifth resistor, the switching between the first and the second divider bridges being carried out by the third transistor (14) of the bipolar type, the base of which is controlled by the first signal (M1) originating from a control circuit (4), this first signal (M1) moreover being applied to the fifth resistor (18) of the second divider bridge.

4. Active antenna according to Claim 3, characterized in that, in the demodulation state, the first signal (M1) is equal to the negative voltage (-V) and the second signal (M2) is modulated between the positive voltage (+V) and the negative voltage (-V) of the power supply (5).

5. Active antenna according to Claim 2, characterized in that a capacitor (C1) is mounted between the gate of the first transistor (10) and the positive voltage (+V) of the power supply (5), of a value such that its time constant is greater than the modulation period of the interrogation signal.

6. Active antenna according to Claim 2, characterized in that a demodulated output is picked up on the drain of the first transistor (10) and addressed to the control circuit (4) of the terminal station (2).

7. Active antenna according to Claim 1, characterized in that the first transistor (10) is the input stage of an integrated-circuit amplifier.

8. Active antenna according to Claim 1, characterized in that it works in the UHF range from 1 to 100 GHz.

FIG_1

FIG_2

FIG_3

FIG_4

FIG_5

FIG_6